## Europäisches Patentamt
## European Patent Office
## Office européen des brevets

(19)

(11) Numéro de publication : **0 143 039**
**B1**

(12) **FASCICULE DE BREVET EUROPÉEN**

(45) Date de publication du fascicule du brevet :
05.04.89

(51) Int. Cl.⁴ : **G 01 R 31/28, G 02 F 1/133**

(21) Numéro de dépôt : **84402170.9**

(22) Date de dépôt : **29.10.84**

(54) **Procédé de fabrication d'une matrice de composants électroniques.**

(30) Priorité : **03.11.83 FR 8317466**

(43) Date de publication de la demande :
**29.05.85 Bulletin 85/22**

(45) Mention de la délivrance du brevet :
**05.04.89 Bulletin 89/14**

(84) Etats contractants désignés :
**DE GB**

(56) Documents cités :
**EP--A-- 0 031 143**
**US--A-- 3 631 411**
**US--A-- 4 053 833**
**IEEE JOURNAL OF SOLID-STATE CIRCUITS, vol. SC-12, no. 3, juin 1977, pages 247-252, New York, US; J.G. SMITH et al.: "Laser testing of integrated circuits"**
**ELEKTRONISCHE RECHENANLAGEN, vol.11, no. 6, décembre 1969, pages 321-329, Munich, DE; W. HIL-BERG: "Zuverlässiger Betrieb von LSI-Speichern mit relativ vielen fehlerhaften Bauelementen"**

(73) Titulaire : **COMMISSARIAT A L'ENERGIE ATOMIQUE 31/33, rue de la Fédération F-75015 Paris (FR)**

(72) Inventeur : **Poujois, Robert "Les Jaillets" F-38650 Sinard (FR)**

(74) Mandataire : **Mongrédien, André et al c/o BREVATOME 25, rue de Ponthieu F-75008 Paris (FR)**

EP 0 143 039 B1

## Description

La présente invention a pour objet un procédé de fabrication d'une matrice de composants électroniques. Elle s'applique à tout arrangement matriciel de composants électroniques et en particulier à une matrice d'éléments utilisée pour la commande d'un écran d'affichage à cristal liquide ou électroluminescent, ou tels que des détecteurs optiques.

Dans une matrice de composants électroniques comportant m lignes et n colonnes de composants reliés électriquement entre eux, l'excitation d'un composant ij situé au croisement de la ligne i, i étant un entier tel que $1 \leqslant i \leqslant m$, et de la colonne j, j étant un entier tel que $1 \leqslant j \leqslant n$, est effectuée en excitant (application d'une tension) simultanément la ligne i et la colonne j de composants.

La commande sélective de ce composant électronique n'est possible que si les composants présentent une caractéristique suffisamment non linéaire autorisant le multiplexage.

Dans le cas d'un imageur-matriciel à cristal liquide, cette caractéristique est représentée par le rapport de la tension appliquée au contraste optique sur l'écran.

Le multiplexage dans un imageur matriciel est facilité par l'addition d'un élément électronique non linéaire (diode, transistor) mis en série avec l'électrode du point élémentaire d'affichage du cristal liquide. L'élément non linéaire permet d'introduire un seuil sur la caractéristique électrooptique de l'effet utilisé.

Sur la figure 1a, on a représenté schématiquement et d'une façon simplifiée l'organisation d'un imageur matriciel non redondante selon la technique actuelle.

L'écran 1 de l'imageur est formé par m lignes et n colonnes de points élémentaires d'affichage 2 formant une matrice.

Le signal vidéo 3 est mis en mémoire dans des échantillonneurs capacitifs $4_1,..., 4_n$ qui stockent une ligne de l'image. Les échantillonneurs sont commandés par un registre à décalage $5_j$ où circule une impulsion qui commande les échantillonnages successifs. L'information vidéo contenue dans l'échantillonneur est transférée dans la ligne de la matrice correspondante où les transistors de commande des points élémentaires d'affichage sont à l'état de conducteurs.

Ces transistors sont commandés par les registres de commande ligne $6_1,..., 6_m$.

Les registres à décalage $5_1,... 5_n$ et les registres de commande ligne $6_1,..., 6_m$ sont commandés par des lignes d'horloge 7 et 8 respectivement.

On effectue un balayage ligne par ligne pour reproduire le signal vidéo sur l'imageur selon une méthode classique appliquée dans les appareils de télévision.

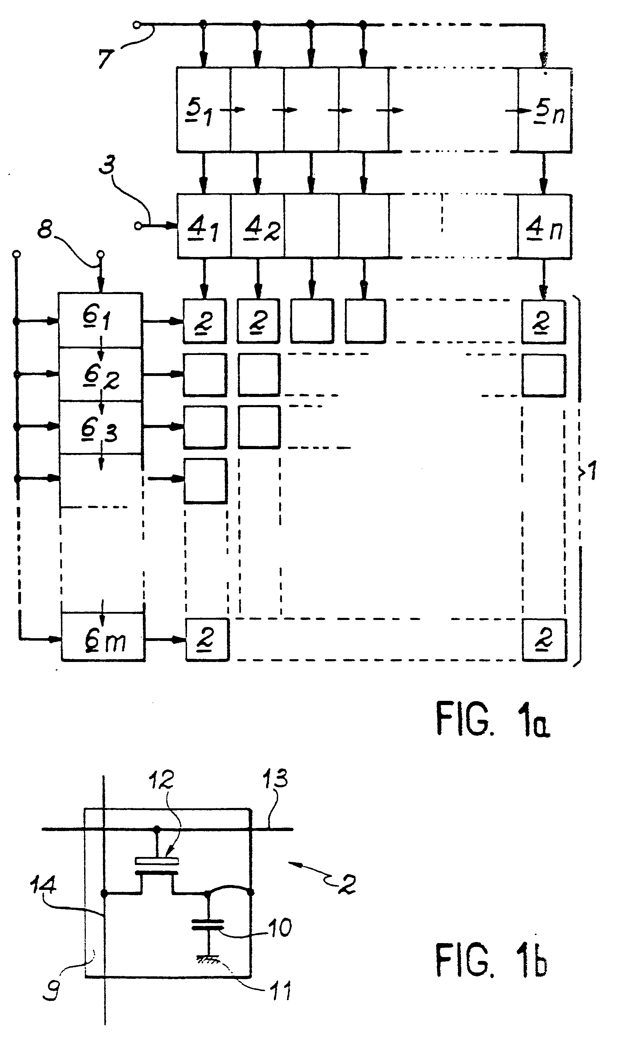

La figure 1b représente un point d'affichage élémentaire d'un imageur à cristal liquide.

L'électrode 9 est disposée sur la face de l'imageur en contact avec le cristal liquide. Une électrode transparente couvrant tout l'écran est disposée sur la face avant du cristal liquide. Cette électrode est tenue à un potentiel constant ; elle peut être reliée à la masse 11 par exemple. Les deux électrodes forment une capacité, représentée par la référence 10, le cristal liquide se trouvant entre les deux électrodes.

Un transistor 12 est branché en série avec l'électrode 9, son drain est relié à la ligne d'interconnexion 14 d'une colonne, sa grille est reliée à une ligne d'interconnexion 13 d'une ligne des points d'affichage. Le transistor 12 est l'élément non linéaire qui autorise le multiplexage des électrodes 9 formant la matrice.

Dans une telle matrice de composants, comme un imageur matriciel, la présence de défauts au niveau des composants électroniques, au niveau des lignes d'interconnexion entre les composants ou dans les circuits de commande des lignes et des colonnes de la matrice entraîne des perturbations du fonctionnement de l'ensemble.

Les défauts les plus gênants dans une matrice sont les coupures de lignes d'interconnexion entre les composants électroniques et les courts-circuits entre les lignes et les colonnes.

Ces défauts sont dus par exemple à une sur- ou sous-gravure de lignes d'interconnexion pendant le procédé de fabrication de la matrice ou bien à la présence de grains de poussière sur un masque pendant l'étape de photolithographie lors de la fabrication de la matrice.

Il peut se produire aussi des courts-circuits au niveau des transistors de commande dans les composants électroniques.

Les défauts concernant uniquement un point élémentaire d'affichage dans un imageur matriciel sont tolérables si le point est suffisamment petit pour ne pas être visible à l'œil nu.

Une coupure d'une ligne d'interconnexion entre les composants électroniques de la matrice ou un court-circuit par contre rend la ligne ou la ligne et la colonne, respectivement, hors service. Des lignes entières défectueuses rendent la matrice ainsi inutilisable.

Jusqu'à présent, les imageurs matriciels réalisés étaient encore trop petits pour la plupart des applications mais trop grands pour que la matrice des composants électroniques soit réalisable avec un bon rendement de fabrication.

Le rendement d'une matrice dépend du nombre et du type de défauts tolérés. A titre indicatif, dans une matrice de $(240)^2$ composants, en tolérant des lignes, colonnes et des points d'affichage élémentaires défectueux, le rendement est d'environ 50 %, mais un tel circuit n'est pas utilisable. En tolérant uniquement des points d'affichage élémentaires défectueux, le rendement de fabrication décline à 10 %. La matrice est utilisable si les points sont suffisamment petits.

Sans défaut, le rendement peut descendre à 1 %. Les rendements peuvent varier suivant la technologie utilisée, mais dans l'ensemble les résultats restent insuffisants.

Pour éviter de tels problèmes et pour augmenter le rendement de fabrication de ces matrices, on peut introduire une redondance sur plusieurs niveaux de la matrice.

Ainsi, on peut réaliser les lignes d'interconnexion entre les composants électroniques en redondance ou l'on utilise une redondance au niveau de chaque composant, c'est-à-dire que l'on multiplie le nombre de composants.

En conséquence, si une ligne d'interconnexion est défectueuse, on peut la remplacer par une autre, qui est une ligne redondante ou dans le deuxième cas, on peut remplacer un composant défectueux par un autre composant voisin.

La fabrication d'une matrice de composants électroniques redondants selon la technique actuelle telle qu'elle est illustrée notamment par le document EP-A-00311 consiste à réaliser les composants et les interconnexions, à tester ensuite la continuité des lignes d'interconnexion, à reconfigurer la matrice en déconnectant les éléments défectueux et en reconnectant les bons entre eux et à relier la matrice des composants électroniques ainsi obtenue à des circuits de commande associés qui se trouvent dans la périphérie de la matrice.

Pour pouvoir effectuer le test de fonctionnement de la matrice, toutes les fonctions redondantes doivent être accessibles individuellement pendant le test.

Celui-ci demande un grand nombre de plots d'accès dans la matrice.

L'encombrement dans la matrice augmente ainsi, ce qui est gênant pour certaines applications comme par exemple pour un imageur à cristal liquide. De plus, il est nécessaire de déplacer les points de test mécaniquement, ce qui rend le procédé de test long et fastidieux.

Selon l'art antérieur, après le test de la matrice, on relie les lignes et les colonnes bonnes aux circuits de commande associés, ces derniers n'étant pas en redondance, on ne peut donc pas tester à la fois le bon fonctionnement de l'ensemble des circuits de commande et la matrice. Ces connexions après test peuvent détériorer les fonctions reconnues bonnes pendant le test.

La présente invention a justement pour but de proposer un procédé de fabrication d'une matrice de composants électroniques permettant de remédier à ces inconvénients. En particulier, elle permet de produire une matrice redondante moins encombrante, d'effectuer le test plus facilement et plus rapidement, comprenant aussi le test des circuits de commande, et d'augmenter ainsi le taux de rendement de fabrication de matrices.

De façon plus précise, l'invention a pour objet un procédé de fabrication d'une matrice de composants électroqniques comprenant m lignes et n colonnes de composants électroniques et des circuits de commande disposés à la périphérie de la matrice, associés à chaque ligne et chaque colonne de composants, caractérisé en ce qu'il consiste à :

— réaliser les composants électroniques de la matrice et les circuits de commande associés sous forme redondante, la matrice étant formée d'éléments redondants, ces éléments redondants étant des sous-ensembles constitués chacun par un certain nombre de composants électroniques associés à leurs circuits de commande, chaque sous-ensemble étant réalisé de façon à être testé à la périphérie de la matrice,

— effectuer le test de chaque sous-ensemble au moyen d'un adressage optique consistant à envoyer des rayons lumineux sur des photodiodes situées à la périphérie de la matrice, reliées à chaque sous-ensemble, certaines de ces photodiodes servant à sélectionner le sous-ensemble à tester, les autres photodiodes servant à engendrer des signaux de test au moyen de rayons lumineux dans le même sous-ensemble ; ce test servant à vérifier, dans chaque sous-ensemble redondant, la continuité des lignes d'interconnexion et le fonctionnement des composants électroniques et des circuits de commande associés, reconstituer, selon le résultat du test, la matrice en déconnectant, dans les sous-ensembles redondants, les composants électroniques défectueux et en reconnectant les bons entre eux.

Selon une autre caractéristique, pour chaque ligne de composants électroniques de la matrice, on réalise sous forme redondante les lignes d'interconnexion de composants électroniques de ladite ligne de composants électroniques et les circuits de commande correspondants, chaque sous-ensemble redondant étant alors constitué de ladite ligne de composants et de ses circuits de commande.

Selon une autre caractéristique, pour chaque colonne de composants électroniques de la matrice, on réalise, sous forme redondante, les lignes d'interconnexion des composants électroniques de ladite colonne de composants électroniques et les circuits de commande correspondants, chaque sous-ensemble redondant étant alors constitué de ladite colonne de composants et de ses circuits de commande.

Selon une autre caractéristique, lorsque m est égal à 2p et n égal à 2q, p et q correspondant au nombre minimum de lignes et de colonnes nécessaire pour l'utilisation prévue de la matrice des composants électroniques et lorsqu'une ligne ou une colonne de la matrice est reconnue défectueuse, la reconstitution de la matrice de composants électroniques est effectuée en connectant les composants électroniques de la ligne ou de la colonne défectueuse avec les composants électroniques correspondants des lignes ou colonnes voisines respectivement.

Selon une autre caractéristique, on teste le fonctionnement de chaque composant électronique au moyen d'un adressage optique consistant à envoyer des rayons lumineux sur une photodiode associée à chaque composant électronique.

Selon une autre caractéristique, on effectue la reconstitution de la matrice au moyen de composants actifs inclus dans les circuits de commande.

Selon une autre caractéristique, on effectue la reconstitution de la matrice, au niveau des circuits de commande, au moyen d'interconnexions passives après avoir détruit les connexions indésirables.

Selon une autre caractéristique, la matrice de composants électroniques est une matrice de transistors permettant de commander un imageur matriciel formée de pixels.

Selon une autre caractéristique, on réalise les circuits de commande, comprenant des registres redondants de telle façon que les registres soient adressables pendant le test par des rayons lumineux au moyen des photodiodes d'adressage reliées aux points de registres et pendant le test, en éclairant une desdites photodiodes, on fait basculer à 1 un point de registre, ce qui connecte une ligne d'interconnexion entre les composants électroniques correspondants sur une sortie test.

Selon une autre caractéristique, l'on réalise une deuxième photodiode à l'autre bout de la ligne d'interconnexion et on applique un rayon lumineux sur ladite photodiode, ce qui produit un courant dans la ligne d'interconnexion qui est observé sur la sortie test, si la ligne n'est pas coupée.

Selon une autre caractéristique, selon le résultat du test des lignes, l'interconnexion entre les registres reconnus défectueux de chaque sous-ensemble est interrompue au moyen de commutateurs, les entrées de ces registres non utilisées étant maintenues à zéro, les registres bons de chaque sous-ensemble étant connectés avec les registres bons du sous-ensemble suivant.

Selon une autre caractéristique, l'état des commutateurs associés à chaque interconnexion est déterminé en coupant ou non la liaison entre une ligne de sélection et les commutateurs d'un sous-ensemble, ce qui permet aux commutateurs de retourner dans une position, imposée par une polarisation.

Selon une autre caractéristique, la reconstitution de la matrice au niveau des registres redondants est effectuée au moyen des interconnexions passives entre les registres de chaque sous-ensemble avec les registres correspondants dans les sous-ensembles suivants. Selon le résultat du test, on déconnecte les registres reconnus défectueux et on connecte les registres redondants bons de chaque sous-ensemble avec des registres bons du sous-ensemble suivant, si cela n'est pas déjà réalisé, au moyen de ces interconnexions réalisées entre eux.

Selon une autre caractéristique, la redondance des différents éléments d'un sous-ensemble est une redondance 2.

Selon une autre caractéristique, la redondance des différents éléments d'un sous-ensemble est une redondance supérieure à 2.

D'autres avantages et caractéristiques de l'invention ressortiront de la description qui suit, donnée à titre illustratif et non limitatif, en référence aux dessins annexés, sur lesquels :

— la figure 1a, déjà décrite, représente schématiquement et d'une façon simplifiée l'organisation d'un imageur matriciel,

— la figure 1b, déjà décrite, représente schématiquement une électrode d'un imageur à cristal liquide avec son transistor de commande, relié à la ligne et à la colonne correspondantes de la matrice,

— les figures 2a-2e représentent schématiquement plusieurs modes de réalisation des redondances au niveau des points élémentaires d'affichage et de leurs transistors de commande,

— la figure 3a représente schématiquement un exemple d'une matrice redondante où les lignes d'interconnexion entre les éléments d'affichage élémentaires et leurs circuits de commande sont réalisés en redondance avec les arrangements de test, comprenant des photodiodes,

— la figure 3b représente schématiquement une électrode d'un imageur matriciel à cristal liquide dont le fonctionnement du transistor de commande peut être testé individuellement au moyen d'une photodiode comprise dans le point d'affichage élémentaire,

— les figures 4a à 4c représentent schématiquement les étapes diverses d'une réalisation des liaisons passives entre les points de registre bons,

— la figure 4d représente schématiquement et en perspective un exemple d'une liaison finalement obtenue,

— la figure 5 représente schématiquement un circuit de composants actifs qui permet de choisir pendant le test la liaison entre des points de registres bons,

— la figure 6 représente schématiquement l'organisation d'une matrice d'un imageur à cristal liquide et la disposition de ses circuits de commande à la périphérie.

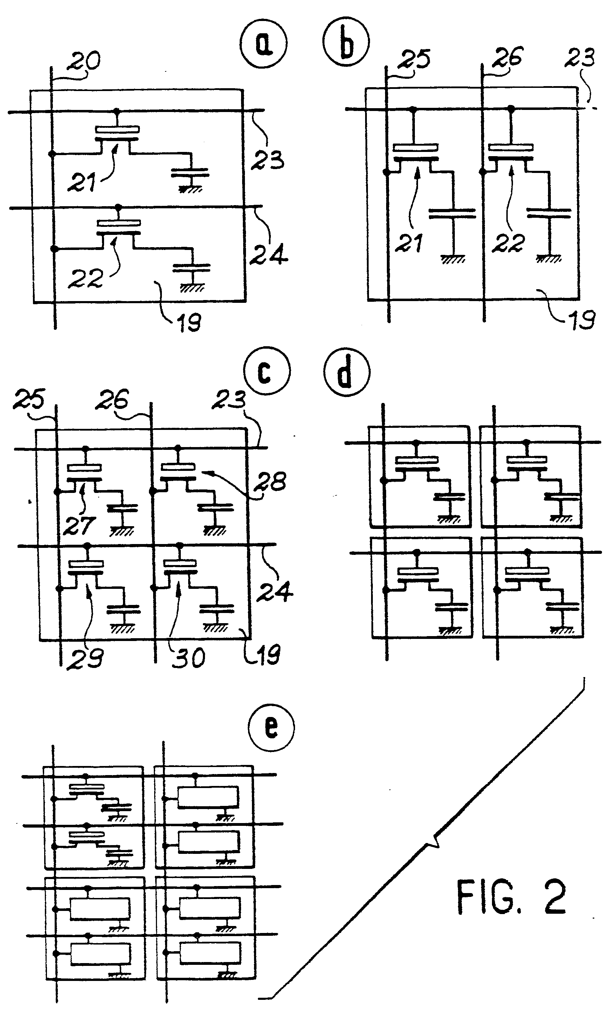

Les figures 2a à 2e représentent schématiquement plusieurs modes de réalisation des redondances au niveau des points élémentaires d'affichage et de leurs transistors de commande.

Dans le texte qui suit, on va dénommer le point élémentaire d'affichage par l'abréviation « pixel », qui est déduit de « picture element » dans la terminologie anglo-saxonne.

La figure 2a représente une électrode 19 d'un pixel, commandé par deux transistors de commande 21, 22. Ici, la redondance est réalisée au niveau des lignes de pixels de l'imageur.

Les sources de chaque transistor 21 et 22 sont reliées à l'électrode 19, les drains sont connectés à la ligne d'interconnexion commune 20 qui réalise la liaison entre tous les pixels d'une colonne de la matrice. Les grilles de chaque transistor 21, 22 sont reliées chacune à une ligne d'interconnexion 23 et 24 respectivement entre les lignes des pixels de la matrice. La redondance dans ce cas est donc réalisée par les deux lignes d'interconnexion 23, 24 entre les pixels d'une ligne de la matrice et par les deux transistors de commande 21, 22 pour chaque pixel.

Si une des lignes d'interconnexion 23 ou 24 entre les lignes de pixels de la matrice est défectueuse, c'est-à-dire coupée par exemple, on utilise l'autre ligne d'interconnexion redondante. La probabilité que toutes les deux lignes d'interconnexion 23 et 24 soient défectueuses est proportionnelle au carré de la probabilité qu'une de ces deux lignes soit défectueuse.

A titre illustratif : si la probabilité d'un défaut dans une ligne d'interconnexion 23 ou 24 est égale à 1 %, la probabilité que toutes les deux lignes d'interconnexion redondantes 23 et 24 soient défectueuses décline à 0,01 %. La fiabilité de cette interconnexion est donc augmentée notablement grâce à la redondance.

La figure 2b représente une deuxième variante de la redondance au niveau des transistors de commande de chaque pixel. Ici, la redondance est réalisée au niveau des colonnes de pixels de l'imageur. Les grilles des deux transistors 21 et 22, commandant une électrode d'un pixel, sont connectées à une ligne d'interconnexion commune 23 qui relie les pixels d'une ligne de la matrice. les drains de chaque transistor 21 et 22 sont chacun connectés à des lignes d'interconnexion séparées 25, 26 qui relient les pixels d'une colonne de la matrice entre eux.

La redondance au niveau des lignes d'interconnexion entre les lignes de pixels et entre les colonnes de pixels de la matrice peut être combinée, ce qui est montré dans la figure 2c. Dans ce cas, une électrode d'un pixel est commandée par quatre transistors 27, 28, 29, 30.

Dans une autre variante, représentée sur la figure 2d, on réalise la redondance au niveau de chaque pixel.

Comme le montre cette figure, au lieu de commander un pixel par 4 transistors, on peut aussi diviser l'électrode en quatre électrodes séparées, chacune étant commandée par un transistor. Dans ce cas, les dimensions de ces quatre électrodes sont choisies de façon qu'elles occupent la même place dans la matrice qu'une seule dans les cas précédents.

Le nombre des pixels de la matrice est donc quadruplé. Le nombre des registres de commande de l'échantillonnage vidéo et de lignes est augmenté d'une manière adéquate, la résolution d'une image reproduite sur la matrice est ainsi augmentée.

Etant donné que la résolution est améliorée d'un facteur deux sur tout l'écran, c'est-à-dire deux fois mieux que nécessaire pour atteindre le but initial, le fait qu'une ligne ou une colonne dans la matrice soit défectueuse, n'entraîne pas de perturbations gênantes à condition que les pixels d'une ligne ou d'une colonne défectueuse soient connectés avec les pixels correspondants sur une ligne ou colonne voisine respectivement.

Cette dernière condition est nécessaire, parce que la défaillance d'une ligne ou une colonne provoque une ligne ou une colonne blanche ou noire sur l'écran, laquelle reste visible, même si l'œil nu ne peut pas résoudre chaque point élémentaire d'affichage. En connectant les pixels de la ligne ou de la colonne défectueuse avec les pixels correspondants de la ligne ou de la colonne précédente et de la ligne ou de la colonne suivante d'une façon alternée, la résolution est ramenée localement à une définition deux fois moins bonne que sur le reste de la matrice, mais il n'y a pas de ligne ou colonne défectueuse visible sur l'écran d'imageur.

On peut bien sûr dans ce cas introduire aussi une redondance au niveau des lignes d'interconnexion d'une façon décrite précédemment. La figure 2e représente, par exemple, la combinaison de la redondance au niveau des électrodes de pixels avec une redondance 2 au niveau des lignes d'interconnexion entre chaque ligne de pixels.

Les lignes d'interconnexion entre les lignes et les colonnes de pixels sont reliées avec leurs circuits de commande à la périphérie de la matrice, c'est-à-dire avec les points de registre, alimentation, horloge, etc.

Selon l'invention, ces circuits de commande aussi réalisés en redondance. Pour deux lignes d'interconnexion redondantes, il y a alors aussi deux points de registre reliés à chacune des lignes d'interconnexion. Les fonctions redondantes, c'est-à-dire les lignes d'interconnexion entre les lignes ou les colonnes des pixels et leurs circuits de commande associés doivent être accessibles individuellement pour un test de fonctionnement sans introduire une grande quantité de plots d'accès ; une sortie commune série est donc préférable.

Il est nécessaire pour le test de découper la matrice en sous-ensembles redondants et de tester chaque sous-ensemble séparément. Si les sous-ensembles sont trop grands, le rendement devient trop faible malgré la redondance, si les sous-ensembles sont trop petits, c'est la reconfiguration qui fait chuter le gain de l'ensemble. En choisissant des lignes et des colonnes de pixels redondantes, présentant une complexité de l'ordre de 500 à 1 000 transistors de commande avec leurs circuits de commande, comme sous-ensembles, on est proche de l'optimum. Les sous-ensembles ainsi conçus ont l'avantage d'être accessibles à la périphérie de la matrice, ce qui facilite le test et la reconfiguration.

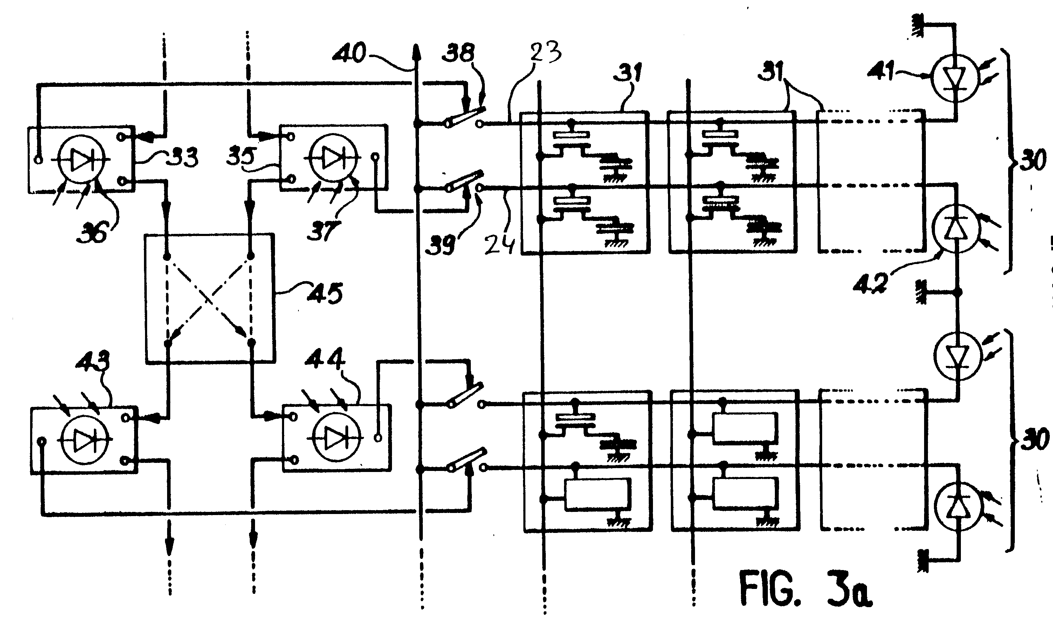

Sur la figure 3a, on a représenté deux sous-ensembles redondants. Chaque sous-ensemble 30 est constitué par une ligne de pixels 31, leurs lignes d'interconnexion 23, 24 en redondance 2 ainsi que par les points de registre 33, 35, associés chacun aux lignes d'interconnexion respectivement 23, 24 correspondantes.

Chaque point de registre 33, 35 comprend respectivement une photodiode 36, 37 permettant par un adressage optique, au moyen d'un faisceau lumineux, de faire basculer à 1 le point de registre respectivement 33, 35 pendant que tous les autres points des registres de la matrice sont maintenus à 0.

Le 1 dans le registre 33, 35 connecte respectivement la ligne correspondante 23, 24 au moyen d'un commutateur respectivement 38, 39 sur la sortie test 40.

Au bout de chaque ligne d'interconnexion 23, 24 est placée une deuxième photodiode respectivement 41, 42. Pendant le test, cette dernière reçoit un faisceau lumineux et produit ainsi un courant dans la ligne d'interconnexion qui sera observé sur la sortie test, si cette ligne d'interconnexion n'est pas coupée. Il est avantageux d'utiliser un signal optique pulsé afin de pouvoir séparer le bruit de fond du signal électrique ainsi produit dans les lignes d'interconnexion et observé à la sortie test. Les lignes d'interconnexion des colonnes sont maintenues à la masse pendant le test.

Ce procédé de test, utilisant un adressage optique permet de tester les différents sous-ensembles de la matrice sans qu'un élément défaillant ne gêne le test des autres sous-ensembles.

On teste ainsi ;
— la rétention ou maintien de 1 ou 0 dans les points de registre,
— la continuité des lignes d'interconnexion,
— l'absence de courts-circuits sur la ligne d'interconnexion.

En transférant le 1 d'un point de registre 33, 35 d'un sous-ensemble à un registre respectivement 43, 44 du sous-ensemble suivant, on teste :
— les liaisons entre les points de registre qui sont de futures reconnexions bénéficiant ainsi de la redondance,
— les lignes d'horloge et les commutateurs qu'elles commandent.

Dans le cas où l'on souhaite avoir une matrice sans défaut, il faut tester chaque pixel individuellement et le corriger s'il y a lieu.

Pour cela, il faut introduire une photodiode dans chaque pixel ; elle doit être assez grande pour recevoir un faisceau lumineux pendant le test au moyen d'un adressage optique.

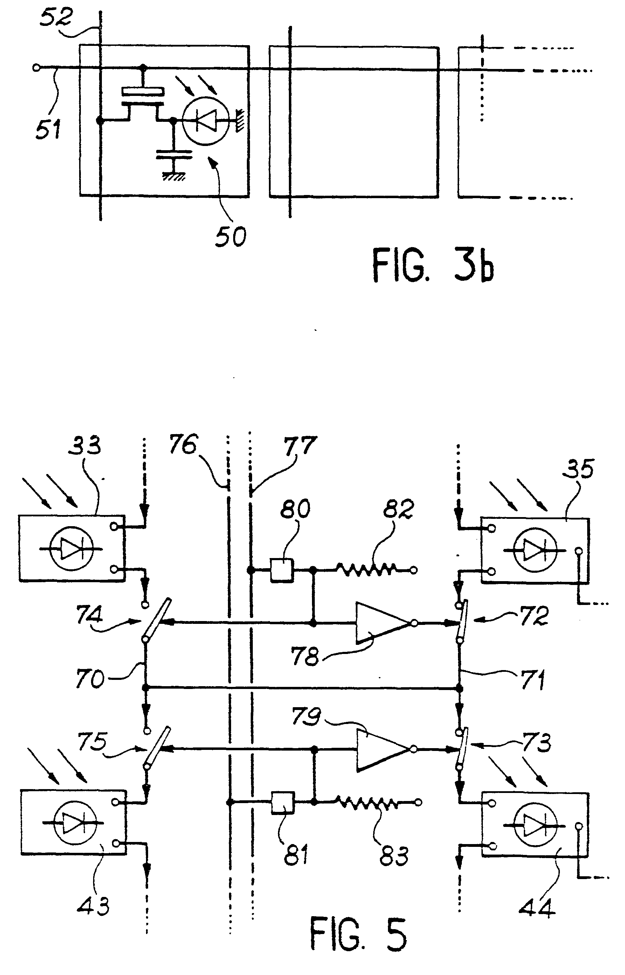

Sur la figure 3b, est représenté un pixel, comprenant une photodiode 50, laquelle est branchée entre la masse et l'électrode de commande du pixel.

La ligne d'interconnexion 51 entre les pixels d'une ligne de la matrice étant reliée à la masse, le signal de test produit par la photodiode 50 illuminée sort par la ligne d'interconnexion 52 entre les pixels d'une colonne de pixels de la matrice. Cette colonne 52 est reliée à un point de registre correspondant. Un adressage optique sur la photodiode 50 de ce point de registre connecte la ligne 52 avec la sortie test. Selon le résultat du test, les pixels défaillants sont reconnectés soit sur la même ligne d'interconnexion redondante, soit sur une ligne voisine s'il n'y a pas de redondance ligne.

La reconstitution de la matrice selon les résultats du test des sous-ensembles, ou des pixels individuellement, peut être effectuée directement pendant ou après le test.

Dans ce dernier cas, les résultats du test sont mémorisés et la reconfiguration est effectuée dans un procédé séparé.

Dans le texte qui suit, le procédé de reconfiguration d'un sous-ensemble constitué par une ligne de pixels, dont les lignes d'interconnexion et leurs circuits de commande associés sont réalisés en redondance 2, comme présenté sur la figure 3a, est décrit.

Si par exemple, le test de la ligne d'interconnexion 24 a montré que celle-ci est défectueuse, on déconnecte tous les transistors de commande de tous les pixels de la ligne qui sont reliés à la ligne d'interconnexion 24. Les déconnexions peuvent être réalisées selon des procédés de gravure classiques, dans la technologie CMOS. Ainsi, on est assuré qu'un transistor de commande éventuellement défectueux, ne peut pas provoquer des perturbations au niveau des colonnes. Ensuite, on déconnecte le point de registre 35 associé à cette ligne d'interconnexion 24 des registres des lignes de pixels précédents et suivants.

Selon l'invention, au niveau des liaisons entre les points de registre, deux circuits d'interconnexion 45 principalement différents sont envisageables.

Les liaisons peuvent être déjà réalisées entre des points de registre de chaque ligne de pixels, qui sont disposés les uns au-dessus des autres, c'est-à-dire que l'on connecte les points de registre 35 et 44 et aussi les points de registre 33 et 43 et ainsi de suite, on réalise ainsi deux registres parallèles.

Selon le résultat du test, si un point de registre ou la ligne d'interconnexion correspondante entre les pixels est défectueux, on coupe les liaisons entre ce registre et les registres précédents et suivants et on réalise une liaison modifiée en remplaçant ce point de registre défectueux par le point de registre redondant associé à la même ligne de pixels, et en reformant la liaison avec les points de registre précédents et suivants.

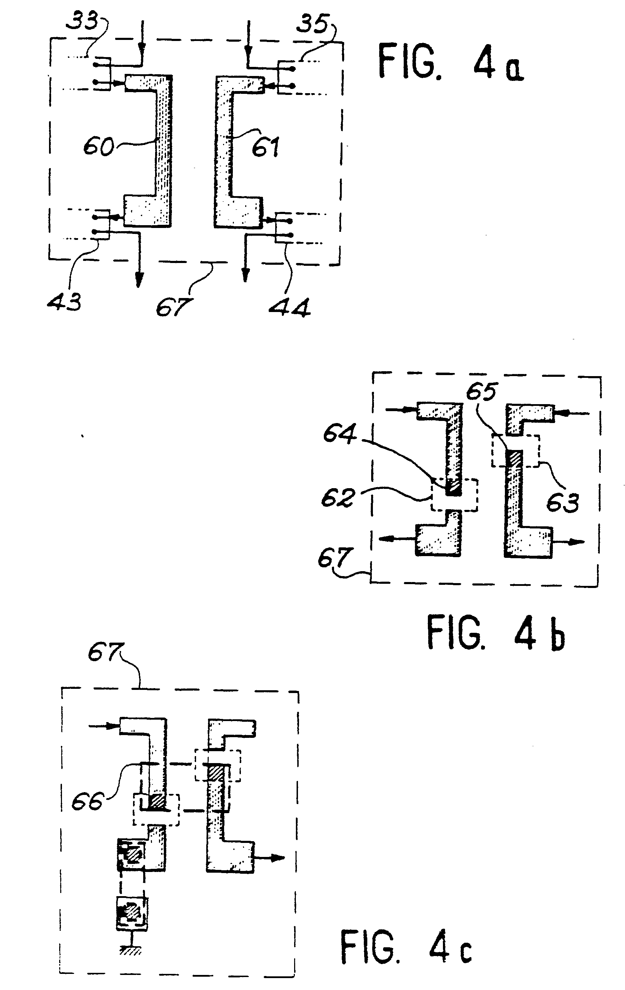

Cette reconnexion au moyen des circuits, dite reconnexion passive, est représentée explicitement sur les figures 4a-4d.

Sur la figure 4a, on voit que les points de registre 33 et 43 et les points de registre 35 et 44 sont reliés entre eux, au moyen de liaisons en aluminium respectivement 60 et 61 par exemple. Si pendant le test, le point de registre 43 est reconnu défectueux, on réalise d'abord deux trous 62 et 63 dans la couche d'oxyde 67, qui couvre les lignes d'aluminium, comme le montre la figure 4b. Ainsi, on a mis à nu les liaisons en aluminium dans ces régions.

Ensuite, on dépose un plot d'aluminium 66 au-dessus des deux trous de contact dans l'isolant 67, afin de réaliser le contact entre les points de registre 33 et 44 et de couper simultanément les liaisons 60 et 61 de façon qu'il reste une partie 64, 65 de ces liaisons qui peuvent être connectées avec les parties des lignes d'aluminium qui vont former la future liaison. Au lieu de couper la ligne 61, connectant les points de registre bons 35 et 44, on peut les laisser connectés. Dans ce cas, on utilise la redondance aussi après le test, c'est-à-dire pendant l'utilisation de la matrice en permanence. Cela présente certains avantages ; en particulier, on a ainsi diminué le nombre d'opérations de modifications des liaisons entre les points de registres successifs. S'il n'y a aucun défaut dans un sous-ensemble, on garde alors tous les points de registre associés en fonction.

Dans une dernière étape, on connecte l'entrée du point de registre défectueux non utilisée 43 avec la masse, afin de définir son potentiel. Le procédé de la réalisation de cette liaison à la masse s'effectue d'une manière analogue à celle décrite ci-dessus et simultanément.

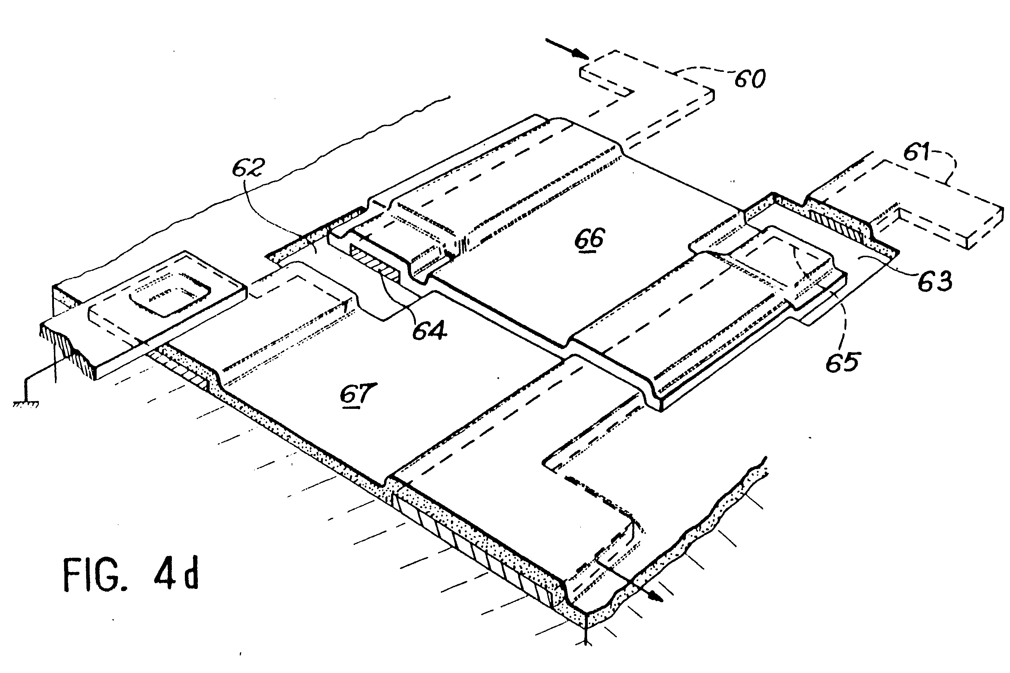

La figure 4d montre en perspective la connexion ainsi obtenue.

Par le procédé décrit ci-dessus, il est alors possible de couper ou créer une liaison entre des points de registre successifs. Dans ce cas, le circuit de reconfiguration des liaisons entre les registres peut avoir une très petite surface (dimension d'un contact) mais il n'est pas possible d'essayer différentes associations de fonctions pendant le test.

Dans une reconfiguration active, un circuit électronique commandé de l'extérieur réalise différentes connexions entre des fonctions pendant le test.

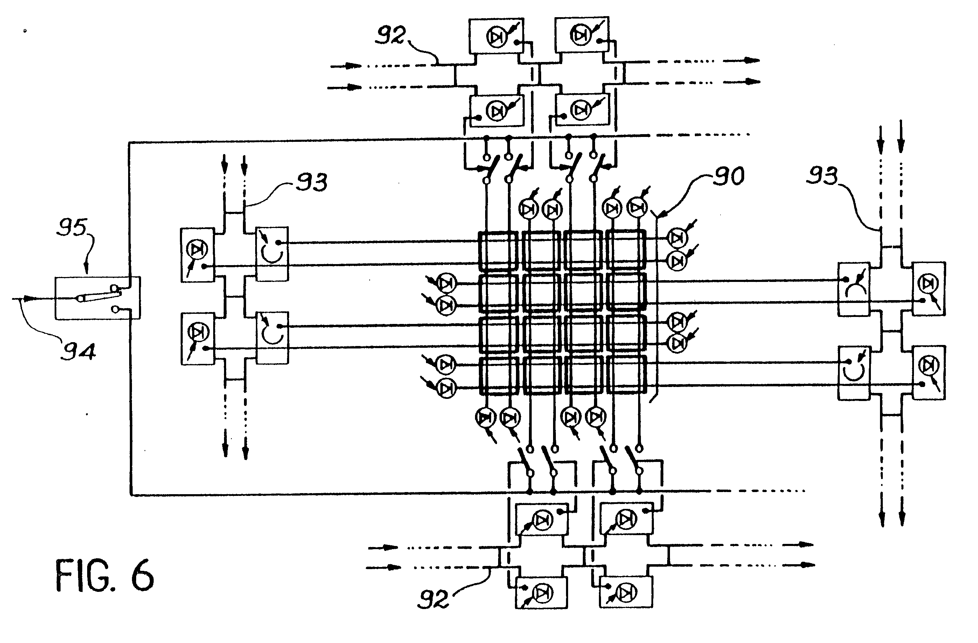

Le circuit électronique de reconfiguration est testé comme les autres fonctions et bénéficie donc de la redondance. La figure 5 montre un exemple d'une reconnexion active.

Sur la figure 5, un circuit de reconfiguration entre quatre points de registre 33, 35, 43, 44 comprend quatre commutateurs 72, 73, 74, 75. Les commutateurs peuvent être réalisés au moyen de transistors CMOS. La sortie du point de registre 33 est reliée avec l'entrée du point de registre 43 au moyen d'une ligne 70 comprenant deux commutateurs 74, 75. De manière analogue, la sortie du point de registre 35 est reliée avec l'entrée du point de registre 44 au moyen d'une ligne 71 comprenant deux commutateurs 72, 73. Les deux lignes 70 et 71 sont reliées entre elles au moyen d'une ligne d'aluminium, leurs points de contact étant situés entre les deux commutateurs de chaque ligne 70 et 71.

Deux commutateurs 74 et 72 ou 75 et 73, tels que des transistors, chacun sur une ligne 70 ou 71 sont commandés par des signaux complémentaires provenant des lignes de sélection 76 et 77. La ligne de sélection 77 par exemple est reliée directement avec le commutateur 74 et par l'intermédiaire d'un inverseur 78 avec le commutateur 72. Une résistance de tirage 82 permet de définir l'état dit standard des deux commutateurs associés, par exemple 74 et 72, c'est-à-dire la fermeture ou l'ouverture du commutateur 74 et inversement l'ouverture ou la fermeture du commutateur 72. Un signal inverse de celui du tirage sur la ligne de sélection 77 permet d'inverser cet état standard. Par exemple, dans un tirage à la masse, une tension engendrée dans la ligne de sélection 77 ferme le commutateur 74 et ouvre le commutateur 72. S'il n'y a pas de tension sur la ligne de sélection, le signal venant de la résistance de tirage 82 inverse les états des commutateurs 74 et 72, c'est-à-dire que le commutateur 74 est ouvert et le commutateur 72 est fermé.

Les commutateurs 75 et 73 sont reliés d'une façon analogue avec la ligne de sélection 76. La résistance de tirage associée porte la référence 83, et l'inverseur associé la référence 79. Avec les quatre combinaisons possibles des signaux dans les lignes de sélection, c'est-à-dire : signal sur la ligne 76, signal sur la ligne 77, ou signal sur la ligne 76, pas de signal sur la ligne 77, ou pas de signal sur la ligne 76, signal sur la ligne 77, ou pas de signal sur la ligne 76, pas de signal sur la ligne 77, on peut essayer les quatre connexions possibles entre les points de registre successifs. Pour choisir définitivement le chemin électrique entre les points de registre successifs, on peut couper ou non les liaisons entre les lignes de sélection 76 ou 77 respectivement et les commutateurs 74 et 72 ou 75 et 73 respectivement. Si on coupe ladite liaison à un endroit prédéterminé 80, 81, les commutateurs sont commandés uniquement par les résistances de tirage.

On a décrit jusqu'ici le procédé de fabrication d'une matrice de composants électroniques en redondance 2 au niveau des lignes d'interconnexion ainsi que des circuits de commande associés et le cas d'une redondance 2 au niveau des composants électroniques.

On peut aussi augmenter la redondance dans ces deux cas en prévoyant au moins 3 lignes d'interconnexion entre les composants ou bien choisir une résolution au moins 3 fois plus grande que nécessaire afin d'atteindre une fiabilité encore plus grande. Cependant, une augmentation de la redondance implique une augmentation de l'encombrement de la matrice ainsi qu'une augmentation du nombre des étapes du test et de la reconfiguration, ce qui peut faire chuter le gain de rendement. Néanmoins, les redondances supérieures à 2 sont envisageables.

L'encombrement des circuits de commande, comprenant des points de registre, des mémoires, des horloges pose déjà des problèmes dans le cas d'une redondance 2.

Selon l'invention, les circuits de commande des colonnes de pixels 92 sont situés d'une façon alternative au-dessus et au-dessous de la matrice de pixels. De même, les circuits de commande des lignes de pixels 93 sont situés d'une façon alternative à droite et à gauche de la matrice.

La figure 6 représente schématiquement l'organisation d'une matrice 90 de pixels d'un imageur à cristal liquide et la disposition de ces circuits de commande 92, 93 à la périphérie. Les circuits situés du même côté de la matrice sont reliés entre eux. L'échantillonnage du signal vidéo 94 et les horloges sont adaptés à cette configuration au moyen des commutateurs 95.

**Revendications**

1. Procédé de fabrication d'une matrice (1) de composants électroniques comprenant m lignes et n colonnes de composants électroniques (31) et des circuits de commande (4, 5, 6) disposés à la périphérie de la matrice, associés à chaque ligne et chaque colonne de composants, caractérisé en ce qu'il consiste à :

réaliser les composants électroniques de la matrice (1) et les circuits de commande associés (4, 5, 6) sous forme redondante, la matrice étant formée d'éléments redondants, les éléments redondants étant des sous-ensembles redondants (30) constitués chacun par un certain nombre de composants électroniques (31) associés à leurs circuits de commande, chaque sous-ensemble (30) étant réalisé de façon à être testé à la périphérie de la matrice (1),

effectuer le test de chaque sous-ensemble (30) au moyen d'un adressage optique consistant à envoyer des rayons lumineux sur les photodiodes (36, 37, 41, 42) situées à la périphérie de la matrice, reliées à chaque sous-ensemble, certaines de ces photodiodes (36, 37) servant à sélectionner le sous-ensemble à tester, les autres photodiodes (41, 42) servant à engendrer les signaux de test au moyen des rayons lumineux dans le même sous-ensemble (30) ; ce test servant à vérifier, dans chaque sous-ensemble redondant, la continuité des lignes d'interconnexion (23, 24) et le fonctionnement des composants électroniques (31) et des circuits de commande (33, 35) associés,

reconstituer, selon le résultat du test, la matrice en déconnectant, dans les sous-ensembles redondants, les composants électroniques (31) défectueux et en reconnectant les bons sous-ensembles (30) entre eux.

2. Procédé selon la revendication 1, caractérisé en ce que, pour chaque ligne de composants électronique de la matrice (1), on réalise sous forme redondante les lignes d'interconnexion (23, 24) de composants électroniques et les circuits de commande correspondants, chaque sous-ensemble redondant étant alors constitué de ladite ligne de composants et de ses circuits de commande.

3. Procédé selon l'une quelconque des revendications 1 et 2, caractérisé en ce que pour chaque colonne de composants électroniques de la matrice (1), on réalise, sous forme redondante, les lignes d'interconnexion (25, 26) des composants électroniques de ladite colonne de composants électroniques et les circuits de commande correspondants, chaque sous-ensemble redondant étant alors constitué de ladite colonne de composants et de ses circuits de commande.

4. Procédé selon l'une quelconque des revendications 1 à 3, caractérisé en ce que, lorsque m est égal à 2p et n égal à 2q, p et q correspondant au nombre minimum de lignes et de colonnes nécessaire pour l'utilisation prévue de la matrice de composants électroniques et lorsqu'une ligne ou une colonne de la matrice est reconnue défectueuse, la reconstitution de la matrice de composants électroniques est effectuée en connectant les composants électroniques de la ligne ou de la colonne défectueuse avec les composants électroniques correspondants de lignes ou colonnes voisines respectivement.

5. Procédé selon la revendication 4, caractérisé en ce que ladite reconstitution est effectuée en connectant les composants de la ligne ou de la colonne défectueuse avec les composants correspondants de la ligne ou de la colonne précédente et de la ligne ou de la colonne suivante et ce, alternativement.

6. Procédé selon la revendication 1, caractérisé en ce que l'on teste le fonctionnement de chaque composant électronique au moyen d'un adressage optique consistant à envoyer des rayons lumineux sur une photodiode (50) associée à chaque composant électronique.

7. Procédé selon la revendication 1, caractérisé en ce que l'on effectue la reconstitution de la matrice au niveau des circuits de commande, au moyen d'interconnexions passives (60, 61, 66) après avoir détruit les connexions indésirables.

8. Procédé selon la revendication 1, caractérisé en ce que l'on effectue la reconstitution de la matrice au moyen de composants actifs (72, 73, 74, 75) inclus dans les circuits de commande.

9. Procédé selon la revendication 7, caractérisé en ce que la reconstitution de la matrice est effectuée pendant le test des sous-ensembles de composants électroniques.

10. Procédé selon la revendication 8, caractérisé en ce que la reconstitution de la matrice est effectuée après le test des sous-ensembles de composants électroniques.

11. Procédé selon la revendication 1, caractérisé en ce que la matrice de composants électroniques est une matrice de transistors (21, 22) permettant de commander un imageur matriciel formé de pixels.

12. Procédé selon la revendication 11, caractérisé en ce que l'on réalise les circuits de commande (4, 5, 6) comprenant des registres redondants de telle façon que les registres soient adressables pendant le test par des rayons lumineux au moyen des photodiodes d'adressage (36, 37), reliées aux points de registres (33, 35) et en ce que, pendant le test, en éclairant une desdites photodiodes (36, 37), on fait basculer à 1 un point de registre (33, 35), ce qui connecte une ligne d'interconnexion (23, 24) entre les composants électroniques correspondants sur une sortie test (40).

13. Procédé selon la revendication 12, caractérisé en ce que l'on réalise une deuxième photodiode (41, 42) à l'autre bout de la ligne d'interconnexion (23, 24) et en ce que l'on applique un rayon lumineux sur ladite photodiode (41, 42), ce qui produit un courant dans la ligne d'interconnexion (23, 24) qui est observé sur la sortie test (40), si la ligne n'est pas coupée.

14. Procédé selon la revendication 13, caractérisé en ce que le rayon lumineux appliqué sur la photodiode est pulsé.

15. Procédé selon la revendication 12, caractérisé en ce que la reconstitution de la matrice au niveau des registres redondants est effectuée au moyen d'interconnexions (45) connectant chaque registre d'un sous-ensemble redondant avec chaque registre du sous-ensemble suivant, les interconnexions comportant des commutateurs (72, 73, 74, 75) commandés par un circuit électronique à l'extérieur qui réalise différentes connexions entre les registres (33, 35, 43, 44) pendant le test.

16. Procédé selon la revendication 15, caractérisé en ce que, selon le résultat du test, l'interconnexion des liaisons entre les registres (33, 35, 43, 44) reconnus défectueux de chaque sous-ensemble est interrompue au moyen des commutateurs (72, 73, 74, 75), les entrées de ces registres non utilisées étant maintenues à zéro, les registres bons de chaque sous-ensemble étant connectés avec les registres bons du sous-ensemble suivant.

17. Procédé selon la revendication 15, caractérisé en ce que les commutateurs (72, 73, 74, 75) sont des transistors CMOS.

18. Procédé selon la revendication 15, caractérisé en ce que l'état des commutateurs (72, 73, 74, 75) associés à chaque liaison (70, 71) est déterminé en coupant ou non la liaison entre une ligne de sélection (76, 77) et les commutateurs (72, 73, 74, 75) d'un sous-ensemble, ce qui permet aux commutateurs de retourner dans une position, imposée par une polarisation.

19. Procédé selon la revendication 12, caractérisé en ce que la reconstitution de la matrice au niveau des registres redondants est effectuée au moyen d'interconnexions passives (60, 61, 66) entre les registres de chaque sous-ensemble avec les registres correspondants dans les sous-ensembles suivants, et en ce que selon le résultat du test, on déconnecte les registres reconnus défectueux et on connecte les registres redondants bons de chaque sous-ensemble avec des registres bons du sous-ensemble suivant, si cela n'est pas déjà réalisé, au moyen de ces interconnexions (66) réalisées entre eux.

20. Procédé selon la revendication 19, caractérisé en ce que les interconnexions passives sont des lignes préétablies entre les registres correspondants de chaque sous-ensemble et sont recouvertes par un masque d'oxyde (67) dans lequel on réalise des trous (62, 63) pour couper lesdites lignes d'interconnexion (60, 61) et/ou pour mettre à nu lesdites lignes d'interconnexion (60, 61) afin de reconnecter les registres bons avec une ligne d'interconnexion (66) au-dessus du masque d'oxyde, au cours d'une opération technologique appropriée.

21. Procédé selon la revendication 19, caractérisé en ce que l'on réalise une liaison entre les lignes d'interconnexion des registres reconnus défectueux avec la masse afin de définir le potentiel à l'entrée des registres non utilisés.

22. Procédé selon l'une quelconque des revendications 15 à 21, caractérisé en ce que les résultats du test sont mémorisés et la reconstitution de la matrice est effectuée après le test.

23. Procédé selon l'une quelconque des revendications 1 à 22, caractérisé en ce que la redondance des différents éléments d'un sous-ensemble est une redondance 2.

24. Procédé selon l'une quelconque des revendications 1 à 22, caractérisé en ce que la redondance des différents éléments d'un sous-ensemble est une redondance supérieure à 2.

25. Procédé selon l'une quelconque des revendications 11 à 24, caractérisé en ce que la disposition des circuits de commande des colonnes (92) des pixels est choisie d'une façon alternative d'un côté et du côté opposé de la matrice de pixels, les circuits de commande des lignes (93) de pixels sont situés d'une façon alternative de l'un et de l'autre côtés restants de la matrice, les circuits situés d'un même côté de la matrice étant respectivement reliés entre eux, l'échantillonnage du signal vidéo (94) et les horloges étant adaptés à cette configuration au moyen de commutateurs (95).

## Claims

1. Process for the production of a matrix (1) of electronic components having m rows and n columns of electronic components (31) and control circuits (4, 5, 6) located at the periphery of the matrix, associated with each row and each column of components, characterized in that it comprises realizing the electronic components of the matrix (1) and the associated control circuits (4, 5, 6) in redundant form, the matrix being formed by redundant elements which are redundant subassemblies (30), each constituted by a certain number of electronic components (31) associated with their control circuits, each subassembly (30) being realized in such a way that it can be tested at the matrix (1) periphery ; performing the test of each subassembly (30) by means of an optical addressing consisting of transmitting light rays onto photodiodes (36, 37, 41, 42) located at the matrix periphery and connected to each subassembly, certain of these photodiodes (36, 37) being used for selecting the subassembly to be tested and the other photodiodes (41, 42) being used to produce test signals by means of light rays in the same subassembly (30) ; said test being used to check, in each redundant subassembly the continuity of the interconnection lines (23, 24) and the operation of the electronic components (31) and the associated control circuits (33, 35) ; reconstituting the matrix, as a function of the test result, by disconnecting within the redundant subassemblies the defective electronic components (31) and reconnecting the satisfactory subassemblies (30).

2. Process according to claim 1, characterized in that for each row of electronic components of the matrix (1), the interconnection lines (23, 24) of electronic components of said row of electronic components are produced in redundant form, together with the corresponding control circuits, each redundant subassembly thus being formed from the said row of components and its control circuits.

3. Process according to either of the claims 1 and 2, characterized in that for each column of electronic components of the matrix (1), the interconnection lines (25, 26) of the electronic components of said column of electronic components and the corresponding control circuits are produced in redundant form, each redundant subassembly then being formed by the said column of components and its control circuits.

4. Process according to any one of the claims 1 to 3, characterized in that when m is equal to 2p and n is equal to 2q, p and q corresponding to the minimum number of rows and columns necessary for the intended use of the matrix of electronic components and when a row or column of the matrix is detected as being defective, the reconstitution of the matrix of electronic components is carried out by connecting the electronic components of the defective row or column to the corresponding electronic components of the respectively adjacent rows or columns.

5. Process according to claim 4, characterized in that the said reconstitution is carried out by connecting the components of the defective row or column to the corresponding components of the preceding row or column and the succeeding row or column in an alternating manner.

6. Process according to claim 1, characterized in that the operation of each electronic component is tested by means of optical addressing consisting of transmitting light rays onto a photodiode (50) associated with each electronic component.

7. Process according to claim 1, characterized in that the reconstitution of the matrix at the control circuits takes place by means of passive interconnections (60, 61, 66) after destroying the undesirable connections.

8. Process according to claim 1, characterized in that the reconstitution of the matrix takes place by means of active components (72, 73, 74, 75) included in the control circuits.

9. Process according to claim 7, characterized in that the reconstitution of the matrix takes place during the testing the of the subassemblies of electronic components.

10. Process according to claim 8, characterized in that the reconstitution of the matrix takes place after testing the subassemblies of the electronic components.

11. Process according to claim 1, characterized in that the matrix of electronic components is a matrix of transistors (21, 22) making it possible to control a matrix display formed by picture elements.

12. Process according to claim 11, characterized in that the control circuits (4, 5, 6) comprising redundant registers are produced in such a way that the registers can be adressed during the test by light beams using addressing photodiodes (36, 37) connected to the register points (35, 36) and during the test, by illuminating one of said photodiodes (36, 37) a register point (33, 35) is switched to 1, which connects an interconnexion line (23, 24) between the corresponding electronic components to a test output (40).

13. Process according to claim 12, characterized in that a second photodiode (41, 42) is provided at the other end of the interconnection line (23, 24) and a light ray is applied to said photodiode (41, 42), which produces a current in the interconnection line (23, 24) which is observed at the test output (40) if the line is not broken.

14. Process according to claim 13, characterized in that the light ray applied to the photodiode is pulsed.

15. Process according to claim 12, characterized in that the reconstitution of the matrix at the redundant registers takes place by means of interconnections (45) connecting each register of a redundant subassembly to each register of the following subassembly, the interconnections incorporating switches (72, 73, 74, 75) controlled by an external electronic circuit, which produces the different connections between the registers (33, 35, 43, 44) during the test.

16. Process according to claim 15, characterized in that as a function of the test result, the interconnection of the connections between the registers (33, 35, 43, 44) recognized as defective of each subassembly is interrupted by means of switches (72, 73, 74, 75), the inputs of said unused registers being kept at zero, the satisfactory registers of each subassembly being connected to the satisfactory registers of the following subassembly.

17. Process according to claim 15, characterized in that the switches (72, 73, 74, 75) are CMOS transistors.

18. Process according to claim 15, characterized in that the state of the switches (72, 73, 74, 75) associated with each connection (70, 71) is determined by interrupting or not interrupting the connection between a selection line (76, 77) and the switches (72, 73, 74, 75) of a subassembly, which makes it possible for the switches to return to a position imposed by a polarization.

19. Process according to claim 12, characterized in that the reconstitution of the matrix at the redundant registers is carried out by means of passive interconnexions (60, 61, 66) between the registers of ·each subassembly and the corresponding registers in the following subassemblies and in that as a function of the test result, the defective registers are disconnected and the satisfactory redundant registers of each subassembly are connected to the satisfactory registers of the following subassembly, if this has not already been done, by means of said interconnections (66) between them.

20. Process according to claim 19, characterized in that the passive interconnections established beforehand between the corresponding registers of each subassembly are covered by an oxide mask (67) in which holes (62, 63) are formed in order to interrupt the interconnection lines (60, 61) and/or for baring said interconnection lines (60, 61), in order to reconnect the satisfactory registers to an interconnection line (66) above the oxide mask during an appropriate technological operation.

21. Process according to claim 19, characterized in that a connection is produced between the interconnection lines of the defective registers and earth, in order to define the potential at the input of the unused registers.

22. Process according to any one of the claims 15 to 21, characterized in that the test results are stored and the reconstitution of the matrix takes place after the test.

23. Process according to any one of the claims 1 to 22, characterized in that the redundancy of the different elements of a subassembly is a redundancy of 2.

24. Process according to any one of the claims 1 to 22, characterized in tghat the redundancy of the different elements of a subassembly is a redundancy higher than 2.

25. Process according to any one of the claims 11 to 24, characterized in that the arrangement of the control circuits of the columns (92) of pixels is chosen in an alternating manner above and below the matrix of pixels, the control circuits of the rows (93) of pixels being positioned in an alternating manner to the right and left of the matrix, the circuit located on the same side of the matrix being respectively interconnected, the sampling of the video signal (94) and the clocks being adapted to said configuration by means of switches (95).

**Patentansprüche**

1. Verfahren zur Herstellung einer Matrix (1) aus elektronischen Bauteilen, enthaltend m Zeilen und n Spalten elektronischer Bauteile (31) und Steuerschaltungen (4, 5, 6), die am Rand der Matrix angeordnet sind und jeder Zeile und jeder Spalte von Bauteilen zugeordnet sind, dadurch gekennzeichnet, daß es umfaßt :

Ausführen der elektronischen Bauteile der Matrix (1) und der zugehörigen Steuerschaltungen (4, 5, 6) in redundanter Form, wobei die Matrix aus redundanten Elementen gebildet ist, die redundanten Elemente redundante Unterbaugruppen (30) sind, die jeweils durch eine gewisse Anzahl elektronischer Bauteile (31) gebildet sind, die ihren Steuerschaltungen zugeordnet sind, wobei jede Unterbaugruppe (30) so ausgeführt ist, daß sie am Rand der Matrix (1) geprüft wird,

Prüfen einer jeden Unterbaugruppe (30) mittels einer optischen Adressierung, die darin besteht, Lichtstrahlen auf Photodioden (36, 37, 41, 42) zu richten, die am Rand der Matrix angeordnet sind und mit jeder Unterbaugruppe verbunden sind, wobei gewisse dieser Photodioden (36, 37) dazu dienen, die zu prüfende Unterbraugruppe auszuwählen, wobei die anderen Photodioden (41, 42) dazu dienen, die Prüfsignale mittels der Lichtstrahlen in dieselbe Unterbraugruppe (30) einzuleiten ; wobei diese Prüfung dazu dient, in jeder redundanten Unterbraugruppe die Durchgängigkeit von Verbindungsleitungen (23, 24) und die Funktion elektronischer Bauteile (31) und der zugehörigen Steuerschaltungen (33, 35) zu prüfen,

Wiederherstellen der Matrix entsprechend dem Prüfergebnis, indem in den redundanten Unterbaugruppen die defekten elektronischen Bauteile (31) abgetrennt werden und indem die guten Unterbaugruppen (30) wieder miteinander verbunden werden.

2. Verfahren nach Anspruch 1, dadurch gekennzeichnet, daß für jede Zeile elektronischer Bauteile der Matrix (1) man in redundanter Form die Verbindungsleitungen (23, 24) der elektronischen Bauteile der genannten Zeile elektronischer Bauteile mit den zugehörigen Steuerschaltungen ausführt, wobei jede redundante Unterbaugruppe so aus der genannen Zeile von Bauteilen und ihren Steuerschaltungen gebildet wird.

3. Verfahren nach einem der Anspruch 1 und 2, dadurch gekennzeichnet, daß für jede Spalte elektronischer Bauteile der Matrix (1) man in redundanter Form die Verbindungsleitungen (25, 26) der elektronischen Bauteile der genannten Spalte elektronischer Bauteile mit den zugehörigen Steuerschaltungen ausführt, wobei jede redundante Unterbaugruppe so aus der genannten Spalte von Bauteilen und ihren Steuerschaltungen gebildet wird.

4. Verfahren nach einem der Ansprüche 1 bis 3, dadurch gekennzeichnet, daß, wen m gleich 2p und n gleich 2q ist, wobei p und q der Minimalzahl von Zeilen und Spalten entspricht, die für die vorgesehene Verwendung der Matrix elektronischer Bauteile notwendig ist, und wenn eine Zeile oder eine Spalte der Matrix als fehlerhaft erkannt wird, die Wiederherstellung der Matrix elektronischer Bauteile ausgeführt wird, indem die elektronischen Bauteile der defekten Zeile oder Spalte mit den entsprechenden elektronischen Bauteilen benachbarter Zeilen bzw. Spalten verbunden werden.

5. Verfahren nach Anspruch 4, dadurch gekennzeichnet, daß die genannte Wiederherstellung ausgeführt wird, indem die Bauteile der defekten Zeile oder Spalte mit entsprechenden Bauteilen der vorhergehenden Zeile oder Spalte und der nachfolgenden Zeile oder Spalte, und dies abwechselnd, verbunden werden.

6. Verfahren nach Anspruch 1, dadurch gekennzeichnet, daß man die Funktion eines jeden elektronischen Bauteils mittels einer optischen Adressierung prüft, die darin besteht, Lichtstrahlen auf eine Photodiode (50) zu senden, die jedem elektronischen Bauteil zugeordnet ist.

7. Verfahren nach Anspruch 1, dadurch gekennzeichnet, daß man die Wiederherstellung der Matrix in Höhe der Steuerschaltungen mittels passiver Verbindungen (60, 61, 66) ausführt, nachdem man die unerwünschten Verbindungen zerstört hat.

8. Verfahren nach Anspruch 1, dadurch gekennzeichnet, daß man die Wiederherstellung der Matrix mittels aktiver Bauteile (72, 73, 74, 75) ausführt, die in den Steuerschaltungen enthalten sind.

9. Verfahren nach Anspruch 7, dadurch gekennzeichnet, daß die Wiederherstellung der Matrix während der Prüfung der Unterbaugruppen elektronischer Bauteile ausgeführt wird.

10. Verfahren nach Anspruch 8, dadurch gekennzeichnet, daß die Wiederherstellung der Matrix nach der Prüfung der Unterbaugruppen elektronischer Bauteile ausgeführt wird.

11. Verfahren nach Anspruch 1, dadurch gekennzeichnet, daß die Matrix elektronischer Bauteile eine Matrix aus Transistoren (21, 22) ist, die einen aus Bildpunkten bestehenden Matrixbildschirm zu steuern gestatten.

12. Verfahren nach Anspruch 11, dadurch gekennzeichnet, daß man die Steuerschaltungen (4, 5, 6), die redundante Register enthalten, derart ausführt, daß die Register während der Prüfung durch die Lichtstrahlen mittels Adressierphotodioden (36, 37) adressierbar sind, die mit Registerpunkten (33, 35) verbunden sind, und daß während der Prüfung man die genannten Photodioden (36, 37) beleuchtet, man einen Registerpunkt (33, 35) um 1 hin- und herschwingen läßt, was eine Verbindungsleitung (23, 24) zwischen den zugehörigen elektronischen Bauteilen auf einen Prüfausgang (40) schaltet.

13. Verfahren nach Anspruch 12, dadurch gekennzeichnet, daß man eine zweite Photodiode (41, 42) am anderen Ende der Verbindungsleitung (23, 24) herstellt und daß man einen Lichtstrahl auf die genannte Photodiode (41, 42) richtet, was einen Strom in der Verbindungsleitung (23, 24) erzeugt, der am Prüfausgang (40) beobachtet wird, wenn die Leitung nicht unterbrochen ist.

14. Verfahren nach Anspruch 13, dadurch gekennzeichnet, daß der auf die Photodiode gerichtete Lichtstrahl pulsiert.

15. Verfahren nach Anspruch 12, dadurch gekennzeichnet, daß die Wiederherstelung der Matrix in Höhe der redundanten Register mittels Verbindungen (45) ausgeführt wird, die jedes Register einer redundanten Unterbaugruppe mit jedem Register der nachfolgenden Unterbaugruppe verbinden, wobei die Verbindungen Schalter (72, 73, 74, 75) enthalten, die durch eine elektronische Schaltung von außen gesteuert werden, die während der Prüfung unterschiedliche Verbindungen zwischen den Registern (33, 35, 43, 44) herstellt.

16. Verfahren nach Anspruch 15, dadurch gekennzeichnet, daß in Abhängigkeit vom Prüfergebnis die Verbindung von Verbindungen zwischen den Registern (33, 35, 43, 44), die als fehlerhaft erkannt worden sind, jeder Unterbaugruppe mittels der Schalter (72, 73, 74, 75) unterbrochen wird, wobei die Eingänge dieser nicht verwendeten Register auf Null gehalten werden und die guten Register einer jeden Unterbaugruppe mit den guten Registern der nachfolgenden Unterbaugruppe verbunden werden.

17. Verfahren nach Anspruch 15, dadurch gekennzeichnet, daß die Schalter (72, 73, 74, 75) CMOS-Transistoren sind.

18. Verfahren nach Anspruch 15, dadurch gekennzeichnet, daß der Zustand der einer jeden Verbindung (70, 71) zugeordneten Schalter (72, 73, 74, 75) bestimmt wird, indem die Verbindung zwischen einer Wählleitung (76, 77) und den Schaltern (72, 73, 74, 75) einer Unterbaugruppe unterbrochen wird, oder nicht, was es den Schaltern erlaubt, in einen Zustand zurückzukehren, der durch eine Polarisation bestimmt ist.

19. Verfahren nach Anspruch 12, dadurch gekennzeichnet, daß die Wiederherstellung der Matrix in Höhe der redundanten Register mittels passiver Verbindungen (60, 61, 66) zwischen den Registern einer jeden Unterbaugruppe mit den entsprechenden Registern der nachfolgenden Unterbaugruppen ausgeführt wird und daß entsprechend dem Prüfergebnis man die als fehlerhaft erkannten Register abtrennt und man die redundanten guten Register einer jeden Unterbaugruppe mit den guten Registern der nachfolgenden Unterbaugruppe verbindet, sofern dies nicht bereits mittels dieser zwischen ihnen hergestellten Verbindungen (66) realisiert ist.

20. Verfahren nach Anspruch 19, dadurch gekennzeichnet, daß die passiven Verbindungen voreingerichtete Leitungen zwischen den entsprechenden Registern einer jedern Unterbaugruppe sind und durch eine Oxidmaske (67) abgedeckt sind, in der man Löcher (62, 63) erzeugt, um die genannten Verbindungsleitungen (60, 61) aufzutrennen und/oder um die genannten Verbindungsleitungen (60, 61) freizulegen, um die guten Register mit einer Verbindungsleitung (66) über der Oxidmaske durch ein geeignetes technologisches Verfahren wieder zu verbindern.

21. Verfahren nach Anspruch 19, dadurch gekennzeichnet, daß man eine Verbindung zwischen den Verbindungsleitungen der als fehlerhaft erkannten Register mit Masse herstellt, um das Potential am Eingang der nicht verwendeten Register festzulegen.

22. Verfahren nach einem der Ansprüche 15 bis 21, dadurch gekennzeichnet, daß die Prüfergebnisse gespeichert werden und die Wiederherstellung der Matrix nach der Prüfung ausgeführt wird.

23. Verfahren nach einem der Ansprüche 1 bis 22, dadurch gekennzeichnet, daß die Redundanz der verschiedenen Elemente einer Unterbaugruppe eine Zweierredundanz ist.

24. Verfahren nach einem der Ansprüche 1 bis 22, dadurch gekennzeichnet, daß die Redundanz der verschiedenen Elemente einer Unterbaugruppe eine über 2 liegende Redundanz ist.

25. Verfahren nach einem der Ansprüche 11 bis 24, dadurch gekennzeichnet, daß die Disposition der Steuerschaltungen der Bildpunktspalten (92) in abwechselnder Weise von einer Seite und der gegenüberliegenden Seite der Bildpunktmatrix gewählt wird, wobei die Steuerschaltungen der Bildpunktzeilen (93) in abwechselnder Weise auf der einen und der anderen verbliebenen Seite der Matrix liegen, wobei die auf der gleichen Seite der Matrix liegenden Schaltungen jeweils untereinader verbunden sind und die Eichung des Videosignals (94) und die Takte an diese Konfiguration mittels Schaltern (95) angepaßt werden.

FIG. 1a

FIG. 1b

FIG. 2

FIG. 3a

30
30
41
42
31
31
23
24
38
39
40
37
45
44
35
33
36
43

3

**FIG. 3b**

**FIG. 5**

FIG. 4 a

FIG. 4 b

FIG. 4 c

FIG. 4d

60

61

62

63

64

65

66

67

EP 0 143 039 B1

FIG. 6

EP 0 143 039 B1